Europäisches Patentamt

European Patent Office

Office européen des brevets

(11) Publication number: **0 125 651**
**B1**

(12) **EUROPEAN PATENT SPECIFICATION**

(45) Date of publication of patent specification: **31.10.90**

(51) Int. Cl.⁵: **G 01 N 24/10**

(21) Application number: **84105337.4**

(22) Date of filing: **11.05.84**

(54) A method for detecting cancerous cells.

(30) Priority: **13.05.83 JP 83651/83**
**23.12.83 JP 243453/83**
**27.03.84 JP 58664/84**

(43) Date of publication of application:
**21.11.84 Bulletin 84/47**

(45) Publication of the grant of the patent:
**31.10.90 Bulletin 90/44**

(84) Designated Contracting States:
**BE CH DE FR GB IT LI NL SE**

(56) References cited:
**FR-A-2 121 723**

**BRITISH JOURNAL OF CANCER, vol. 41, 1980,
pages 356-359, GB; J.A. GREEN et al.: "Electron
spin resonance studies on caeruloplasmin and
iron transferrin in patients with chronic
lymphocytic leukaemia"**

(73) Proprietor: **Special Reference Laboratories, Inc.**
**4-1, Nishi-shinjuku 2-chome**
**Shinjuku-ku Tokyo 160 (JP)**

(73) Proprietor: **JEOL Ltd.**
**1418 Nakagamicho**
**Akishimashi Tokyo 196 (JP)**

(72) Inventor: **Aoyama, Masaaki c/o Special Ref. Lab.**
**4-1 Nishi-shinjuku 2-chome**
**Shinjuku-ku, Tokyo 160 (JP)**
Inventor: **Itabashi, Mitsuharu c/o Special Ref.
Lab.**
**4-1 Nishi-shinjuku 2-chome**
**Shinjuku-ku, Tokyo 160 (JP)**
Inventor: **Miura, Mariko c/o Special Ref. Lab.**
**4-1 Nishi-shinjuku 2-chome**
**Shinjuku-ku, Tokyo 160 (JP)**
Inventor: **Kohno, Masahiro c/o JEOL Ltd.**
**1418 Nakagamicho**
**Akishimashi, Tokyo 196 (JP)**

(74) Representative: **Liedl, Gerhard**
**Steinsdorfstrasse 21 - 22**
**D-8000 München 22 (DE)**

(56) References cited:

**PHOTOBIOCHEMISTRY AND PHOTOBIOPHYSICS, vol. 3, 1982, pages 353-363, Amsterdam, NL; S. CANNISTRARO et al.: "Quantum yield of electron transfer and of singlet oxygen production by porphyrins: An ESR study"**

**PHYSICS IN MEDICINE AND BIOLOGY, vol. 22, no. 5, 1977, pages 949-957, London, GB; A.E. PROFIO et al.: "A feasibility study of the use of fluorescence bronchoscopy for localization of small lung tumours"**

## Description

The present invention relates to a method for detecting cancerous cells and for diagnosis of cancer in vitro.

In a known method of cancer diagnosis a light-sensitive material such as hematoporphyrin which has an affinity for tumors is intravenously injected and the material is allowed to accumulate in the tumor for three days or more. Then a laser beam is applied to the tumor through an optical fiber guide and the fluorescence radiation from the tumor, resulting from the laser beam irradiation, is observed.

A similar method using a mercury vapour lamp and an image intensifier has been described by A.E. Profio and D.R. Doiron in Phys. Med. Biol., 1977, Vol. 22, No. 5, 949 to 957.

As the diagnosis is performed in vivo and requires considerable time for the accumulation, it is unavoidable that a patient will experience both physical and mental discomfort. It is desirable to reduce the discomfort to a patient to a minimum.

The object of the present invention is to provide an accurate method for detecting cancerous cells in vitro and a correct method for diagnosis of cancer in vitro within a short period of time.

This object is achieved by the features of claims 1, 4 and 11 and the features of claim 14, respectively.

Features of the present invention include:

(a) cells taken from a patient are mixed with a solution of hematoporphyrin or a hematoporphyrin derivative;

(b) cells from the mixture are isolated and an ESR spectrum of said cells is obtained;

(c) a value $S_x$ respresentative of the quantity of the radicals in said cells is determined; and

(d) value $S_x$ is compared at a predetermined level.

Another feature is that other information regarding the g-value is also taken into consideration. Other features and advantages of the present invention will be apparent by reading the descriptions accompanying the drawings.

Brief description of the drawings:

Fig. 1 shows the structural formula of hematoporphyrin;

Fig. 2 shows an ESR spectrum of hematoporphyrin;

Fig. 3 shows procedures for handling lymphocytes in the present invention;

Fig. 4 shows ESR spectra of cells from a person in good health and of cells from a cancer patient obtained according to the procedure shown in Fig. 3;

Fig. 5 shows the relation between the number of cells and the relative intensity of an ESR signal;

Fig. 6 shows the voracity influence of macrophages in lymphocytes;

Fig. 7 shows the relative intensity of ESR signals from the lymphocytes of seven persons in good health, 19 cancer patients and six HB hepatitis patients, and the relative intensity of ESR signals from cancerous cells K562 and HGC-25, the Fig. 3 procedure being used;

Fig. 8 shows the relative intensity of ESR signals from lymphocytes of 26 cancer patients, 22 persons in good health and five patients with SLE, the procedure shown in Fig. 3 and a hematoporphyrin derivative being used;

Fig. 9 shows ESR signals of cells from a person in good health and of cells from a cancer patient;

Fig. 10 shows g-values of ESR signals from the lymphocytes of 19 cancer patients, 16 persons in good health and four cancer patients after surgery;

Fig. 11 shows values of the quantity of radicals contained in lymphocytes of 19 cancer patients, 16 persons in good health and four cancer patients after surgery;

Fig. 12 shows the plotted distribution of all samples shown in Fig. 10 and Fig. 11 using g - S coordinates;

Fig. 13 shows the relation between S and a parameter Ky;

Fig. 14 shows the relation between S and a parameter Kf;

Fig. 15 shows the layout of a system used for detection with the present invention; and

Fig. 16 shows an operation flow chart of the system shown in Fig. 15.

The present invention is based on a novel discovery that cells, such as lymphocytes, extracted from venous blood of a cancer patient provide valuable information on the cancer, and that the information can be obtained by making hematoporphyrin or a hematoporphyrin derivative affect these cells. Therefore, the quantity of the radicals contained in the cells is measured with an ESR spectrometer.

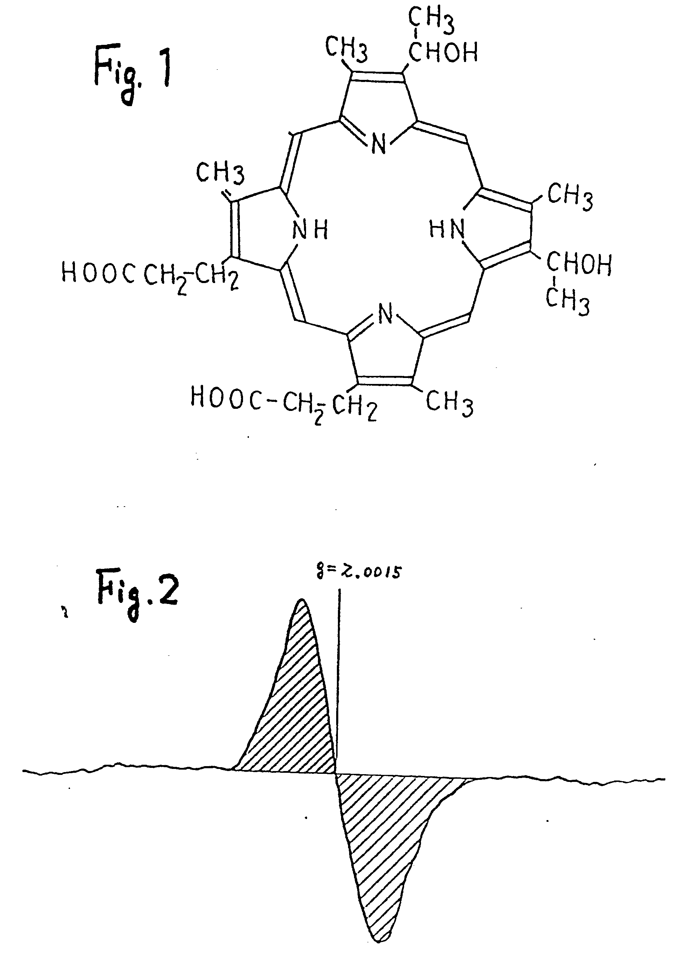

Hematoporphyrin, the structural formula of which is shown in Fig. 1, and its derivatives generate porphyrin radicals when exposed to light; these radicals can be detected with an ESR spectrometer together with those radicals which the cells originally possessed.

Fig. 2 shows an ESR signal of radicals derived from hematoporphyrin. The ESR signal g-value of said radicals is 2.0015, however, the value is not fixed. In order to improve sensitivity, the spectrum is obtained at a temperature of 173°K.

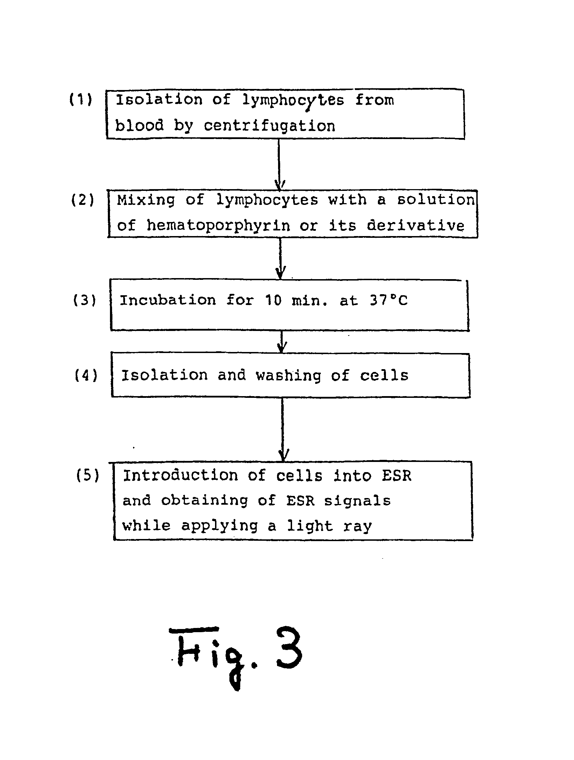

With the present invention, measurement is performed according to the following procedure (in digest form in Fig. 3):

(1) By centrifugation, isolating lympmocytes (not containing monocytes) from silica-treated blood extracted from a patient;

(2) Mixing said lymphocytes with 50 µl of 0.005 mol/l solution of hematoporphyrin or a hematoporphyrin derivative;

(3) Incubating the mixture for about 10 minutes at a temperature of 37°C;

(4) Isolating lymphocytes from unreacted reagent by 5 minutes centrifugation at 1,500 rpm., and washing said lymphocytes in a physiological saline solution;

(5) Introducing a predetermined number of lymphocytes, which are suspended in 200 µl of physiological saline solution, into the ESR spectrometer; obtaining an ESR signal while applying a light ray (ultraviolet ray from a mercury lamp) to the lymphocytes at a temperature of 173°K.

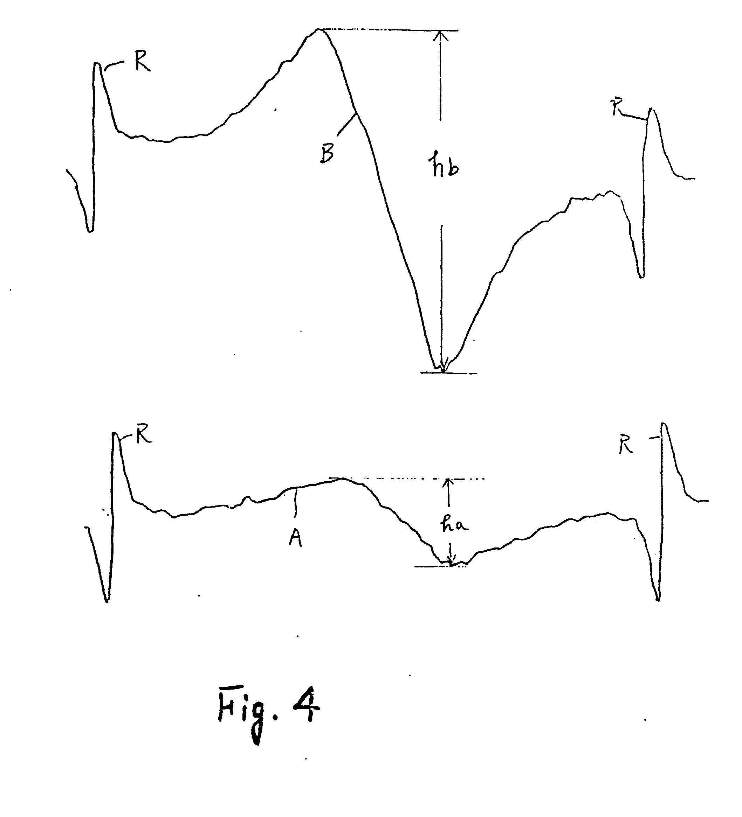

In Fig. 4, "A" is an ESR signal of cells from a person in good health and "B" and ESR signal of cells from a cancer patient. Both were obtained according to the procedure shown in Fig. 3. In Fig. 4 "R" is an ESR signal of a standard sample mixed with lymphocytes for providing a standard intensity and g-value. It is clear that the amplitude $h_b$ of the signal of cells from a cancer patient is twice as large as the amplitudes $h_a$ of the signal of cells from a person in good health; accordingly, the number of radicals contained in the cancer patient's lymphocytes is much greater than that of the person in good health.

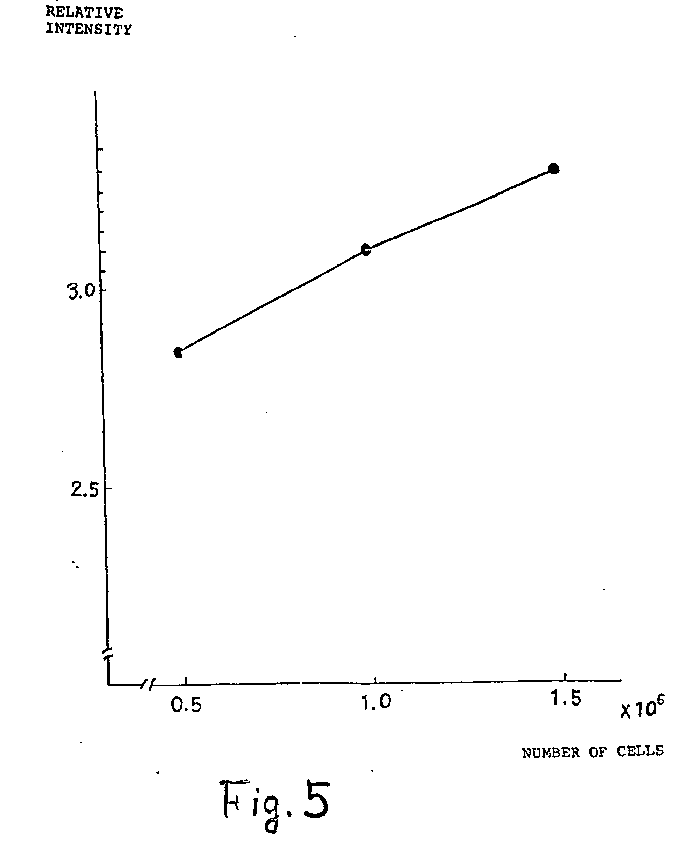

Fig. 5 shows a linear relation between the number of cells and the relative intensity of an ESR signal of tumoral erythron K562.

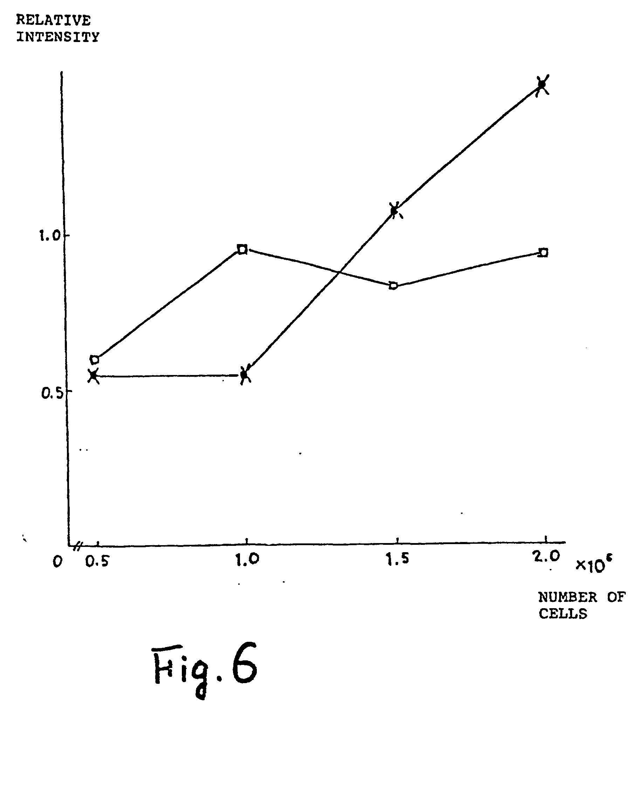

Fig. 6 shows the voracity influence of macrophages in the lymphocytes of a person in good health. The "X" line represents a case in which macrophages are mixed with lymphocytes; the "O" line a case in which the macrophages are removed. The radicals in lymphocytes increase in number when macrophages exist. Accordingly, in order to eliminate the influence of voracity, it is desirable that macrophages be removed with silica gel or the like.

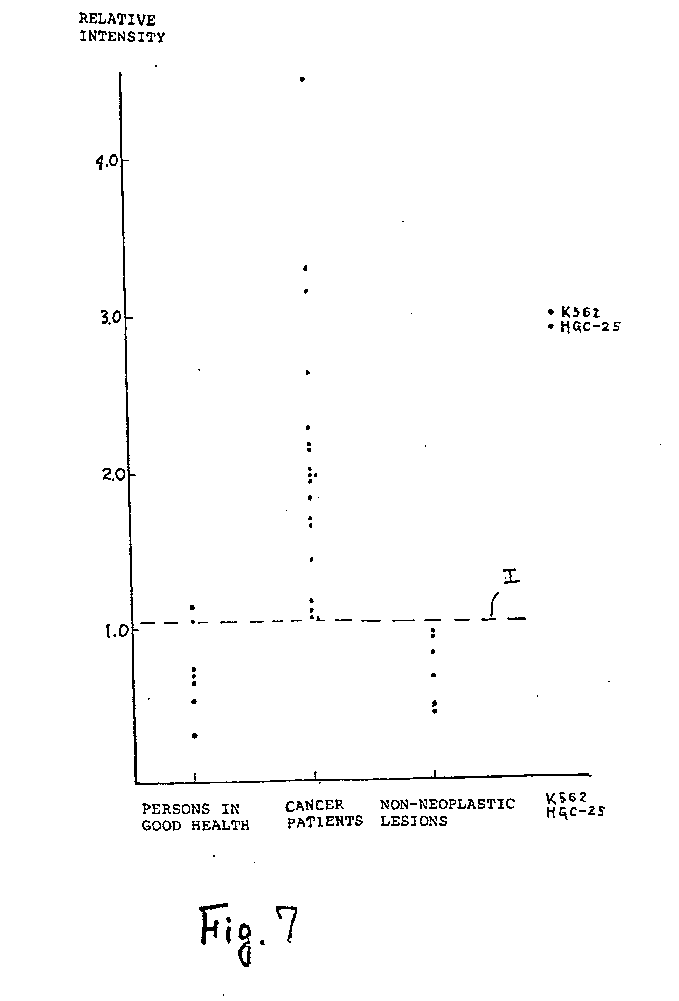

Fig. 7 shows the relative intensity of ESR signals from the lymphocytes of seven persons in good health, 19 cancer patients and six non-neoplastic lesions patients, with each obtained according to the procedures shown in Fig. 3. Likewise, ESR signals from cancerous cells of K562 and HGC-25 were also obtained. It is clear from the figure that since the relative intensity of all cases of cancer patients (mean value: 2.04 ISD 0.86) exceeds the relative intensity in cases of persons in good health (mean value: 0.74 1SD0.28), it is possible to draw a line (1) of demarcation between the cancer patients and the persons in good health.

The intensity for non-neoplastic lesions patients (mean value: 0.74, ISD0.22) who are not cancerous shows little difference from that for persons in good health. On the other hand, the intensity of K562 and HGC-25, both cultured cancerous cells, is exceedingly higher than that for persons in good health. Consequently, it is possible to correctly detect cancer from information regarding the quantity of radicals contained in cells, as obtained according to the Fig. 3 procedure.

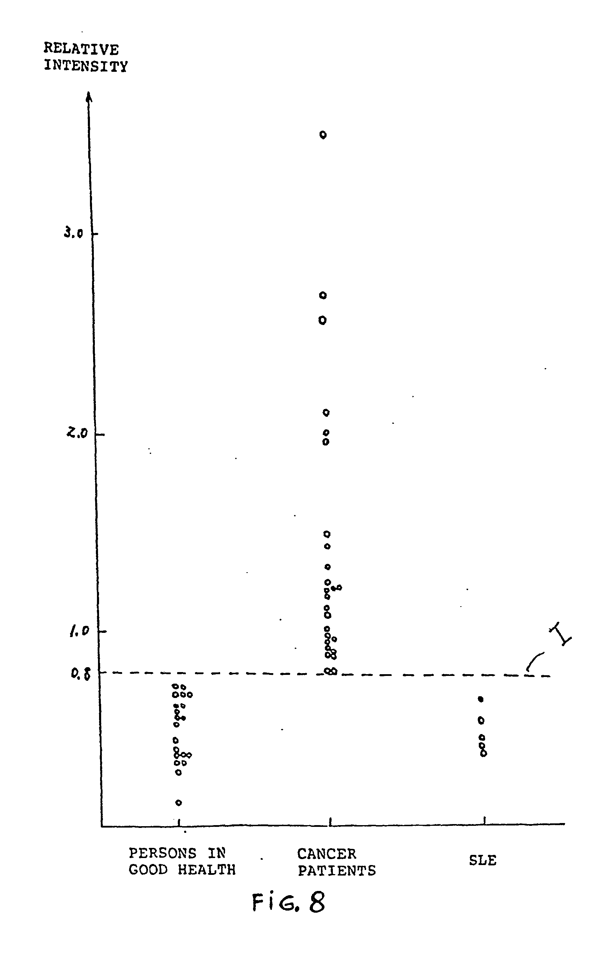

Furthermore, in lieu of hematoporphyrin, a hematoporphyrin derivative brings on still more correct detection. Fig. 8 shows the relative intensity of ESR signals from lymphocytes of 26 cancer patients, 21 persons in good health and five patients with collagen disease, with each obtained according to the Fig. 3 procedure by using a hematoporphyrin in derivative.

In Fig. 8, the relative intensity of signals in cases of all cancer patients exceeds the level of 0.8; on the other hand, the relative intensity for persons in good health and patients with SLE, neither being cancerous, does not exceed said level. Accordingly, Fig. 8 also shows that it is possible to draw a line (1) of demarcation between the cancer patients and other persons and to detect cancer in accordance with the line (1).

As shown in Fig. 7, when hematoporphyrin is used, a small area exists where the values for cancer patients and persons in good health overlaps; however, as shown in Fig. 8, in the cases where a hematoporphyrin derivative is used, such overlapping does not exist. Therefore, a more correct detection of cancer is achieved.

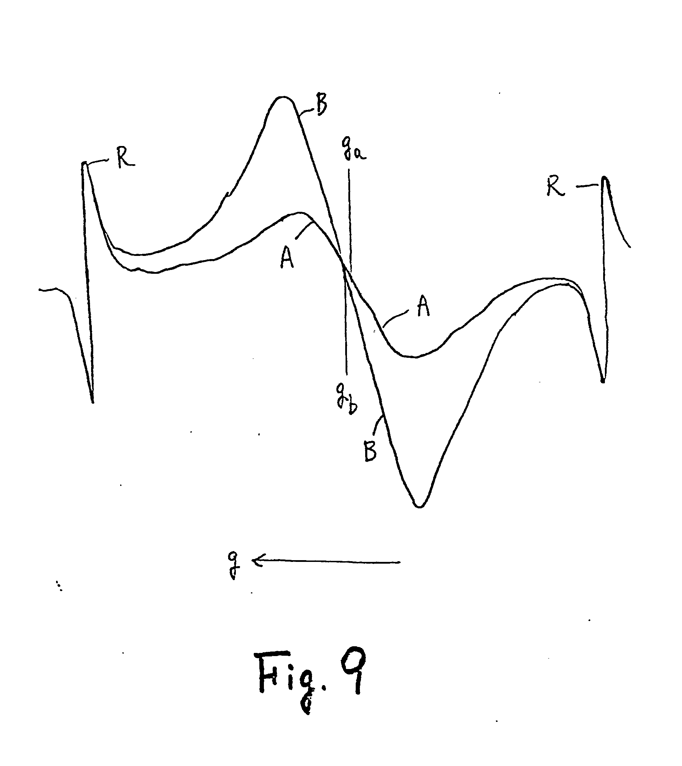

The present inventions have further discovered that ESR signals in cases of cancer patients have a tendency to shift in the direction in which the g-value increases, in addition to the aforesaid tendency of increasing with an increase in the quantity of radicals. In Fig. 9, "A" shows an ESR signal in the case of a person in good health and "B" shows an ESR signal in the case of a cancer patient. It can seen that "B" has a larger intensity than "A" and that "B" shifts in the direction in which the g-value increases from $g_a$ to $g_b$.

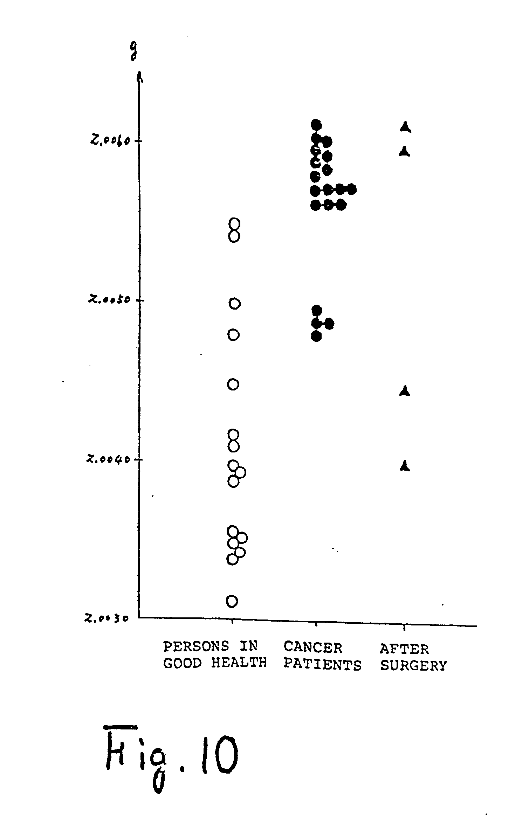

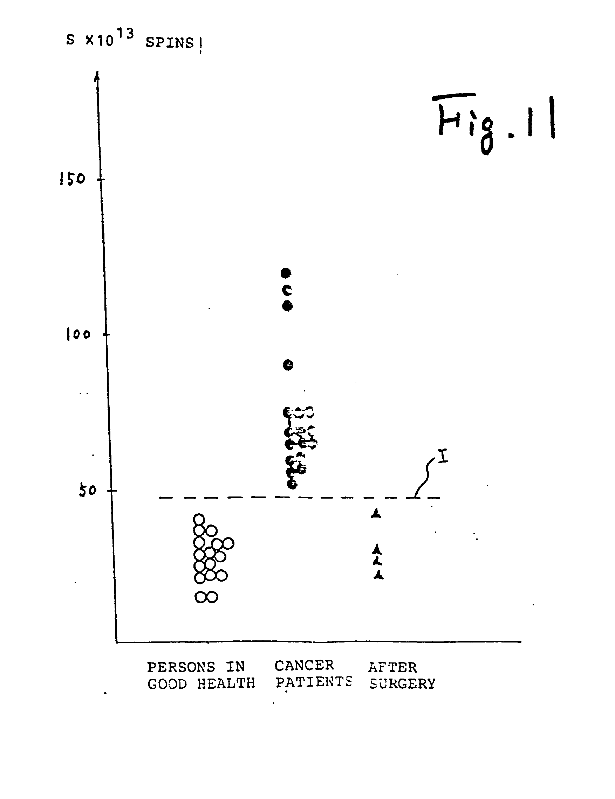

To investigate this phenomenon more clearly, the present inventors have obtained ESR signals of cells from 19 cancer patients, 16 persons in good health and four cancer patients following surgery, according to Fig. 3 procedure, by using a hematoporphyrin derivative. They have established the g-values of the ESR signals and have calculated the quantity of radicals by measuring the superficial content of the ESR signals (shaded area in Fig. 2). Figs. 10 and 11 are the result. Fig. 10 shows the g-values of ESR signals a Fig. 11 the values of a parameter S representing the quantity of radicals, where "0" represents persons in good health, "o" cancer patients and "Δ" cancer patients after surgery.

In accordance with Fig. 10, ESR signals for cancer patients have a salient tendency to appear at the position where the g-value is larger than that for persons in good health; however, ESR signals for some of the cancer patients appear where the g-value is similar to that for a person in good health. Accordingly, there is a small reliability problem when detection of cancer is done on the basis of the g-value only.

On the other hand, in Fig. 11 it is possible to draw a line (1) of demarcation between the cancer patients and persons in good health. However, since all samples range from $20 \times 10^{13}$ spins to $120 \times 10^{13}$ spins, the dynamic range is not sufficiently wide. Because the line of demarcation is drawn in said range, if data near said line contain errors, thee is a possibility of making an incorrect detection of cancer.

To make a correct detection of cancer, two parameters are recommended, namely, a quantitative parameter S for the quantity of radicals and a qualitative parameter for the g-value.

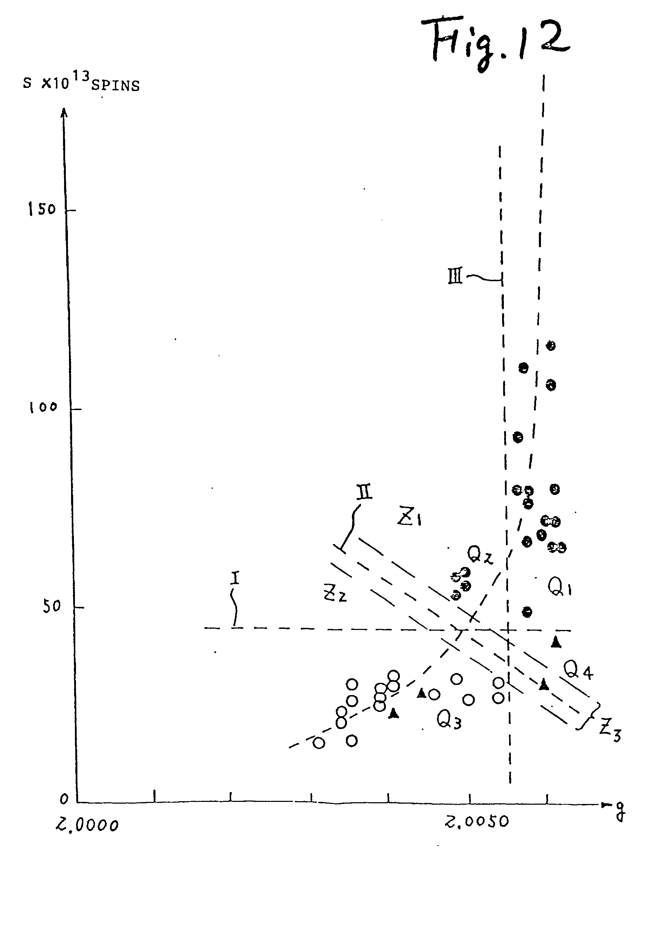

In Fig. 12, all samples shown in Figs. 10 and 11 are plotted in a g - S coordinate system. The line (1) in Fig. 12 is equivalent to the line (1) in Fig. 11. It is clearly seen that since all samples are two-dimensionally distributed in the g - S coordinate system, a demarcation line (11) which is defined by parameters g and S can be drawn in the g - S coordinate system. The line (11) divides the g - S plane into two areas: the upper area $Z_1$ (cancer area) and the lower area $Z_2$ (good health area). Then, after measuring the values $g_x$ and $S_x$ for a new sample (X), by judging the area where the point ($g_x$, $S_x$) locates, it is possible to appreciate whether the new sample exhibits cancer or not. In this case, better reliability is achieved than that in the case when only the one parameter S is taken into consideration. In practice, it is desirable to set the indeterminate area ($Z_3$) in the neighborhood of the line (II).

Furthermore, by drawing a new demarcation line (111) for the g-value, by separating the g - S plane by said line (III) and the aforesaid line (I) into four areas, $Q_1$ (cancer area), $Q_2$ (indeterminate area), $Q_3$ (good health area), and $Q_4$ (indeterminate area), and by determining where the point defined by ($g_x$, $S_x$) locates, it is also possible to determine whether the new sample contains cancer cells or not.

In the case of Fig. 12, data $g_x$ and $S_x$ is used as obtained for defining the position, however, adding some mathematical treatment is effective.

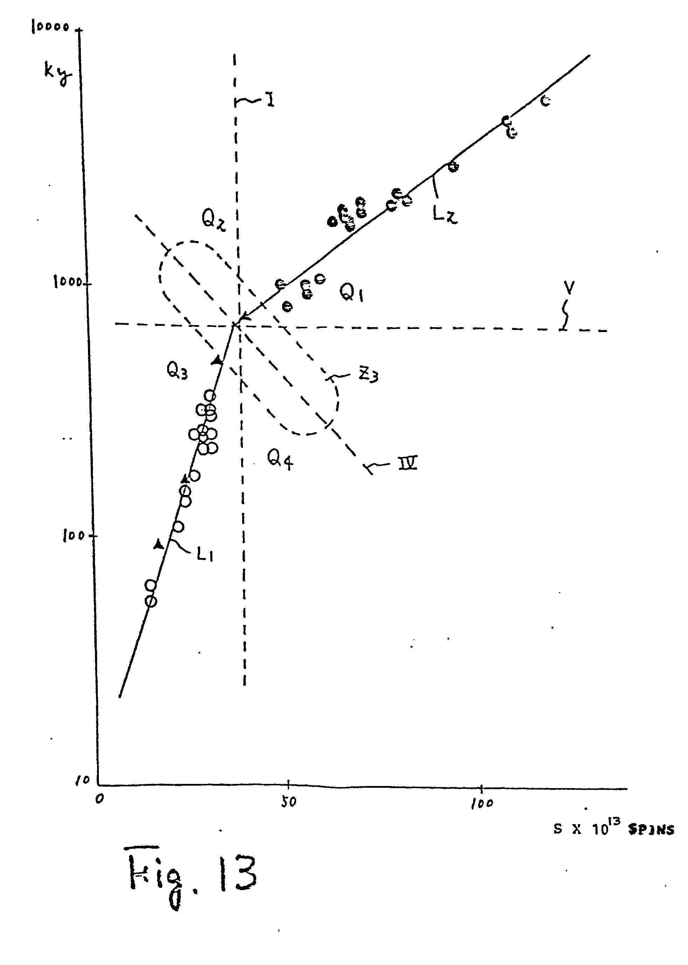

In Fig. 13, samples are plotted using S - Ky coordinates and Ky is defined by the following formula:

$$Ky=((g-g_0)\times 1,000)^{\log S} \qquad (1)$$

where $g_0$ is a constant, for example, $g_0=2.0000$ (in Fig. 13).

It can be understood that a demarcation line (IV) can be drawn on the S - Ky plane, that the line divides said plane into three areas, $Z_1$ (cancer area), $Z_2$ (good health area) and $Z_3$ interdeterminate area). Accordingly, by judging the area where the point ($S_x$, Ky) locates, it is possible to determine whether the new sample contains cancer cells or not.

In Fig. 13, a calibration curve $L_1$ of persons in good health and $L_2$ of cancer patients is drawn. Since the more advanced cases locate at the upper part of $L_2$, the degreee of cancer progression can be known.

Furthermore, for persons in good health, Ky is within the relatively narrow range of 5 through 100; for cancer patients Ky is within the relatively wide range of 100 to 1,000 or more (Fig. 13). Accordingly, it is possible to detect cancer cells without developing in the direction of S. Such being the case, detection is made by observing only the value of $Ky_x$ and judging whether the value exceeds the level of the demarcation line (V) or not. In this case, since the dynamic range of Ky is far wider than the original data (S), resolution and reliability can be improved.

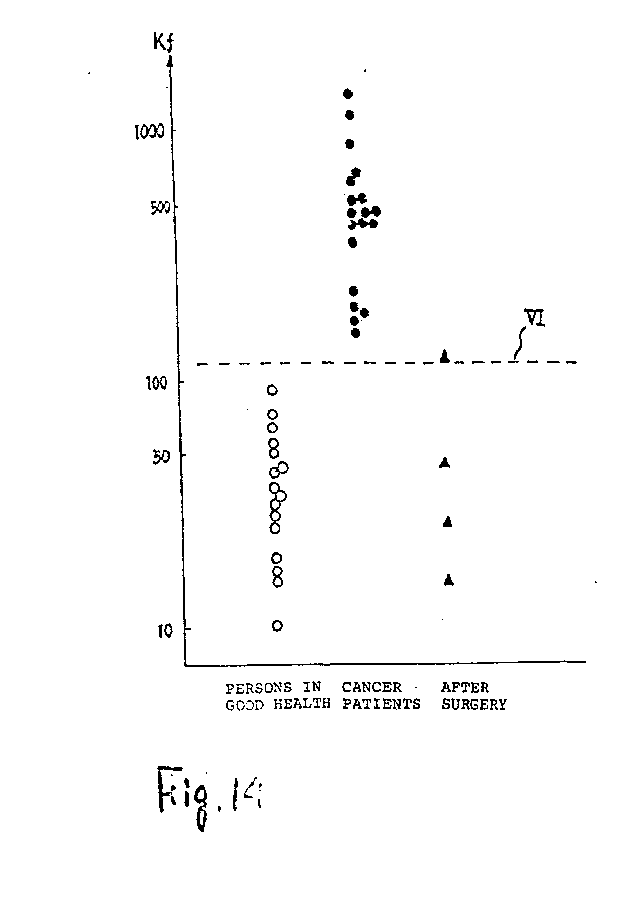

In Fig. 14, all samples are plotted in accordance with the value of Kf, which is defined by the following formula:

$$Kf=(g-G_0)\times 1,000\times \log S \qquad (2).$$

It can be understood that for persons in good health, Kf is within the relatively narrow range of 10 through 100; for cancer patients, Kf is within the relatively wide range of 140 through 1,000 or more. Thus, it is possible to draw a demarcation line (VI) between Kf=100 and Kf=140 and to detect cancer cells according to said line (VI). In this case, since the dynamic range of Kf is far wider than the original data (S), resolution and reliability can be improved.

Since the more advanced cases of cancer indicate a high value of Kf, it is possible to know the degree of progression.

Further, by plotting all samples using the S - Kf coordinates, a graph similar to Fig. 13 is obtained and detecting is possible according to said graph.

In Fig. 15, ESR spectral data obtained with an ESR spectrometer 1 is sent to a computer 2 and stored in the memory 3. Data on demarcation lines I, II, III, IV, V, and VI are stored in the read only memory 4. The results of cancer cell detection performed by the computer 2 are sent to the recorder 5 and/or printer 6.

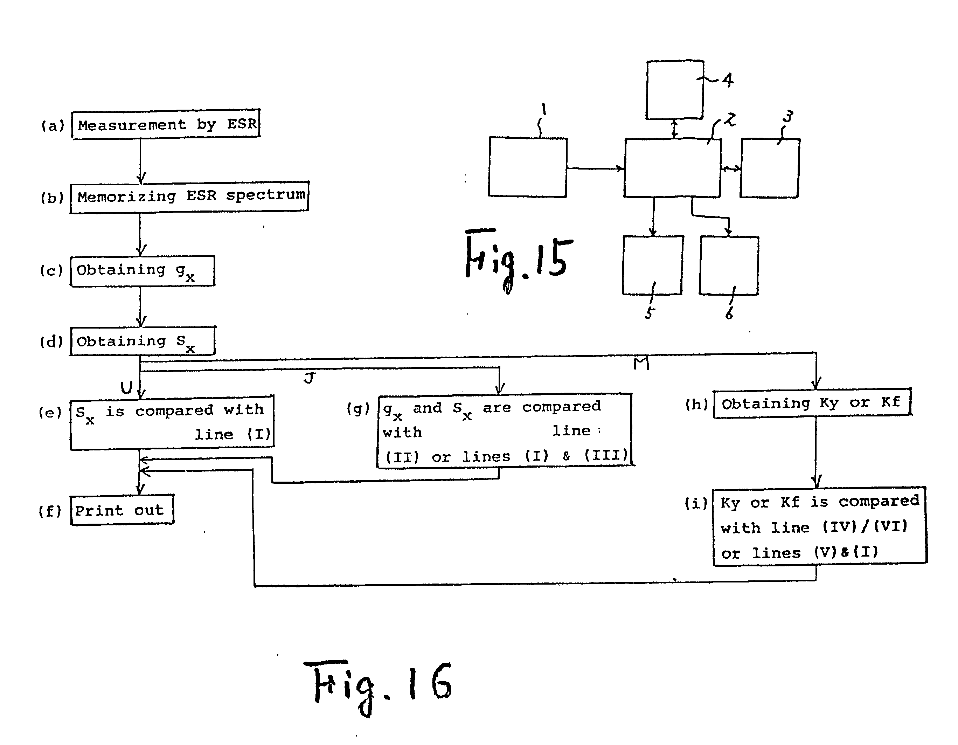

As shown by Fig. 16, the system of Fig. 15 operates as follows:

(a) ESR signals are obtained by the ESR spectrometer 1 from a given sample according to the Fig. 3 procedure;

(b) Spectral data are stored in the memory 3;

(c) The value of $g_x$ is determined from the spectral data by the computer 2;

(d) The value of S is established by computing the superficial content of the ESR signal;

When detection is performed according to the demarcation line (I) folloing the line (U):

(e) Said data of $S_x$ and the data on the demarcation line (I) are compared, and it is determined whether the value of $S_x$ is larger than the level of line (I) or smaller;

(f) The results are printed out by the printer 6.

When detection is made according to the demarcation line (II) or according to the lines (I) and (III) following the line (J):

(g) Said data of $g_x$ and $S_x$ and the data on the demarcation line (II) or lines (I) and (III) are compared, and the area where the point defined by ($S_x$, $g_x$) locates is determined among the good health area, cancer area and indeterminate area;

(f) The results are printed out by the printer 6.

When detection is made according to demarcation lines (IV), (V), or (VI), following the line (M);

(h) The value of $Ky_x$ or $Kf_x$ is found by calculation according to the aforesaid formulas (1) or (2);

(i) Said data of $Ky_x$ or $Kf_x$ and the data on demarcation lines (IV) or (VI), or the data regarding the demarcation lines (V) and (I) are compared, it is determined that the point defined by $Ky_x$ or $Kf_x$ locates in the good health area, cancer area or indeterminate area;

(f) The results are printed out by the printer 6.

In the case of lines (I) and (V), data $S_x$ must also be taken into consideration.

In the preferred investigation, the value of $g_x$ is

determined by the computer 2, however, it is expected that the operator determines the value of $g_x$ on the basis of the ESR spectrum drawn on the chart of the recorder 5, and enters the value of $g_x$ in the computer 2.

**Claims**

1. A method for detecting cancerous cells in vitro, the steps of which include

a) mixing cells from a patient with a solution of hematoporphyrin or a hematoporphyrin derivative,

b) isolating said cells from unreacted reagent and obtaining an ESR spectral signal on said cells,

c) finding a value $S_x$ representative of the quantity of radicals contained in said cells on the basis of the ESR signal, and

d) comparing the value $S_x$ at a predetermined level.

2. The method of claim 1 wherein the ESR spectral signal is obtained at a low temperature.

3. The method of claim 1 or 2 wherein the ESR spectral signal is obtained by irradiating the cells with a light beam.

4. A method for detecting cancerous cells in vitro, the steps of which include

(a) mixing cells from a patient with a solution of hematoporphyrin or a hematoporphyrin derivative,

(b) isolating said cells from unreacted reagent and obtaining an ESR spectral signal on said cells,

(c) finding an S-value $S_x$ representative of the quantity of radicals contained in said cells and finding the g-value $g_x$ of said radicals on the basis of the ESR signals, and

(d) finding the value of a quantity K defined by a predetermined function of S-values and g-values.

5. The method of claim 4 including the further step

(e) comparing the value K at a predetermined level.

6. The method of claim 4 including a further step

(e) for determining the area where the point $S_x$, K locates among the predetermined plural areas on the S - K coordinates.

7. The method of claims 4, 5 and 6 wherein the predetermined function of S-values and g-values in step (d) of claim 4 consists of a substantial multiplication of the S-values and g-values.

8. The method of claims 4, 5 and 6 wherein the predetermined function of S-values and g-values in said step (d) of claim 4 consists of a substantial involution of the g-values to the S-values.

9. The method of claims 4, 5, 6, 7 and 8 wherein the ESR spectral signal is obtained at a low temperature.

10. The method of claims 4, 5, 6, 7, 8 and 9 wherein the ESR spectral signal is obtained by irradiating the cells with a light beam.

11. A method for detecting cancerous cells in vitro, the steps of which include

(a) mixing cells from a patient with a solution of hematoporphyrin or a hematoporphyrin derivative,

(b) isolating said cells from unreacted reagent and obtaining an ESR spectral signal on said cells,

(c) finding an S-value $S_x$ representative of the quantity of radicals contained in said cells and finding the g-value g of said radical on the basis of the ESR signals, and

(d) determining the area where the point $S_x$, $g_x$ locates among the predetermined plural areas on the S - g coordinates.

12. The method of claim 11 wherein the ESR spectral signal is obtained by irradiating the cells with a light beam at a low temperature.

13. The method of claim 11 wherein the ESR spectral signal is obtained by irradiating the cells with a light beam.

14. A method for diagnosis of cancer in vitro utilizing an ESR spectrometer, the steps of which include

(a) isolating lymphocytes from blood extracted from a patient;

(b) mixing said lymphocytes with a solution of hematoporphyrin or a hematoporphyrin derivative,

(c) isolating said lymphocytes from the mixture and obtaining an ESR spectral signal on said lymphocytes,

(d) finding an S-value $S_x$ representative of the quantity of the radicals contained in said lymphocytes on the basis of the ESR signal, and

(e) comparing the value $S_x$ at a predetermined level.

15. The method of claim 14 wherein the ESR spectral signal is obtained at a low temperature.

16. The method of claims 14 and 15 wherein the ESR spectral signal is obtained by irradiating the lymphocytes with a light beam.

**Patentansprüche**

1. Verfahren zum Nachweis von krebsartigen Zellen in vitro, dessen Schritte umfassen

(a) das Vermischen von Zellen von einem Patienten mit einer Lösung von Hämatoporphyrin oder eines Hämatoporphyrinderivates,

(b) das Isolieren der Zellen von nicht umgesetztem Reagenz und das Aunehmen eines ESR-Spektralsignals der Zellen,

(c) das Ermitteln eines die Menge der in den Zellen enthaltenen Radikale darstellenden Wertes $S_x$ aufgrund des ESR-Signals und

(d) das Vergleichen des Wertes $S_x$ mit einem vorbestimmten Wertepegel.

2. Verfahren nach Anspruch 1, bei dem das ESR-Spektralsignal bei einer niedrigen Temperatur erhalten wird.

3. Verfahren nach Anspruch 1 oder 2, bei dem das ESR-Spektralsignal durch Bestrahlen der Zellen mit einem Lichtstrahlenbündel erhalten wird.

4. Verfahren zum Nachweis von krebsartigen Zellen in vitro, dessen Schritte umfassen

(a) das Vermischen von Zellen von einem Patienten mit einer Lösung von Hämatoporphyrin oder eines Hämatoporphyrinderivates,

(b) das Isolieren der Zellen von nicht umgesetztem Reagenz und das Aufnehmen eines ESR-Spektralsignals der Zellen,

(c) das Ermitteln eines die Menge der in den Zellen enthaltenen Radikale darstellenden S-Wertes $S_x$ und das Ermitteln des g-Wertes $g_x$ der Radikale aufgrund der ESR-Signale und

(d) das Ermitteln des Wertes einer Größe K, die durch eine vorbestimmte Funktion von S-Werten und g-Werten definiert ist.

5. Verfahren nach Anspruch 4, umfassend den weiteren Schritt

(e) das Vergleichen des Wertes K mit einem vorbestimmten Wertepegel.

6. Verfahren nach Anspruch 4, umfassend einen weiteren Schritt

(e) zum Bestimmen des einen Feldes von mehreren vorbestimmten Feldern in der S-K-Koordinatendarstellung, in dem sich der Punkt $S_x$, K befindet.

7. Verfahren nach den Ansprüchen 4, 5 und 6, bei dem die vorbestimmte Funktion der S-Werte und g-Werte im Schritt (d) des Anspruchs 4 im wesentlichen aus einer Multiplikation der S-Werte und g-Werte besteht.

8. Verfahren nach den Ansprüche 4, 5 und 6, bei dem die vorbestimmte Funktion der S-Werte und g-Werte im Schritt (d) des Anspruchs 4 im wesentlichen aus einer Involution der g-Werte zu den S-Werten besteht.

9. Verfahren nach den Ansprüchen 4, 5, 6, 7 und 8, bei dem das ESR-Spektralsignal bei einer niedrigen Temperature erhalten wird.

10. Verfahren nach den Ansprüchen 4, 5, 6, 7, 8 und 9, bei dem das ESR-Spektralsignal durch Bestrahlen der Zellen mit einem Lichtstrahlenbündel erhalten wird.

11. Verfahren zum Nachweis von krebsartigen Zellen in vitro, dessen Schritte umfassen

(a) das Vermischen von Zellen von einem Patienten mit einer Lösung von Hämatoporphyrin oder eines Hämatoporphyrinderivates,

(b) das Isolieren der Zellen von nicht umgesetztem Reagenz und das Aufnehmen eines ESR-Spektralsignals der Zellen,

(c) das Ermitteln eines die Menge der in den Zellen enthaltenen Radikale darstellenden S-Wertes $S_x$ und das Ermitteln des g-Wertes $g_x$ der Radikale aufgrund der ESR-Signale und

(d) das Bestimmen des einen Feldes von mehreren vorbestimmten Feldern in der S-g-Koordinatendarstellung, in dem sich der Punkt $S_x$, $g_x$ befindet.

12. Verfahren nach Anspruch 11, bei dem das ESR-Spektralsignal durch Bestrahlen der Zellen mit einem Lichtstrahlenbündel bei einer niedrigen Temperature erhalten wird.

13. Verfahren nach Anspruch 11, bei dem das ESR-Spektralsignal durch Bestrahlen der Zellen mit einem Lichtstrahlenbündel erhalten wird.

14. Verfahren zu Diagnose von Krebs in vitro unter Verwendung eines ESR-Spektrometers, dessen Schritte umfassen

(a) das Isolieren von Lymphocyten aus dem von einem Patienten abgezogenen Blut,

(b) das Vermischen der Lymphocyten mit einer Lösung von Hämatoporphyrin oder eines Hämatoporphyrinderivates,

(c) das Isolieren der Lymphocyten aus der Mischung und das Aufnehmen eines ESR-Spektralsignals der Lymphocyten,

(d) das Ermitteln eines die Menge der in den Lymphocyten enthaltenen Radikale darstellenden S-Wertes $S_x$ aufgrund des ESR-Signals und

(e) das Verleichen des Wertes $S_x$ mit einem vorbestimmten Wertepegel.

15. Verfahren nach Anspruch 14, bei dem das ESR-Spektralsignal bei einer niedrigen Temperature erhalten wird.

16. Verfahren nach den Ansprüchen 14 und 15, bei dem das ESR-Spektralsignal durch Bestrahlen der Lymphocyten mit einem Lichtstrahlenbündel erhalten wird.

**Revendications**

1. Méthode pour détecter in vitro des cellules cancéreuses, comprenant les stades suivants:

a) mélanger des cellules d'une malade avec une solution d'hématoporphyrine ou d'une dérivé d'hématoporphyrine,

b) isoler ces cellules du réactif n'ayant pas réagi et obtenir um signal spectral RSE sur ces cellules,

c) trouver une valeur $S_x$ représentative de la quantité de radicaux contenus dans ces cellules sur la base du signal RSE, et

d) comparer la valeur $S_x$ à une valeur prédéterminée.

2. Méthode selon la revendication 1, dans laquelle le signal spectral RSE est obtenu à basse température.

3. Méthode selon la revendication 1 ou la revendication 2, dans laquelle le signal spectral RSE est obtenu en exposant ces cellules à un faisceau lumineux.

4. Méthode pour détecter in vitro des cellules cancéreuses, comprenant les stades suivants:

(a) mélanger les cellules d'un malade avec une solution d'hématoporphyrine ou un dérivé d'hématoporphyrine,

(b) isoler ces cellules de réactif n'ayant pas réagi et obtenir un signal spectral RSE sur ces cellules,

(c) trouver une valeur de S, $S_x$, représentative de la quantité de radicaux contenus dans ces cellules et trouver le coefficient G, $G_x$, de ces radicaux sur la base des signaux RSE, et

(d) trouver la valeur d'une quantité K définie par une fonction predéterminée des valeurs S et des coefficients G.

5. Méthode selon la revendiction 4, comportant un stade supplémentaire

(e) comparer la valeur K à une valeur prédéterminée.

6. Méthode selon la revendication 4, comportant un stade supplémentaire

(e) pour déterminer la zone dans laquelle se trouve le point $S_x$, K parmi les différentes zones prédéterminées sur le système de coordonnées S-K.

7. Méthode selon les revendications 4, 5 et 6, dans laquelle la fonction prédéterminée des valeurs S et des coefficients K dans le stade (d) de la revendication 4 consiste en une multiplication substantielle des valeurs S et des coefficients G.

8. Méthode selon les revendications 4, 5 et 6, dans laquelle la fonction prédéterminée des valeurs S et des coefficients K dans le stade (d) de la revendication 4 consiste en une involution substantielle des coefficients G en les valeurs S.

9. Méthode selon les revendications 4, 5, 6, 7 et 8, dans laquelle le signal spectral RSE est obtenu à basse température.

10. Méthode selon les revendications 4, 5, 6, 7, 8 et 9, dans laquelle le signal spectral RSE est obtenu en exposant les cellules à un faisceau lumineux.

11. Méthode pour détecter in vitro des cellules cancéreuses, comprenant les stades suivants:

(a) mélanger les cellules d'une malade avec une solution d'hématoporphyrine ou d'un dérivé d'hématoporphyrine;

(b) isoler ces cellules du réactif n'ayant pas réagi et obtenir un signal spectral RSE sur ces cellules,

(c) trouver une valeur de S, $S_x$, représentative de la quantité de radicaux contenus dans ces cellules et trouver la valeur du coefficient G, $G_x$, de ces radicaux sur la base des signaux RSE, et

(d) déterminer la zone dans laquelle se trouve le point $S_x, G_x$, parmi les différente zones prédéterminées dans le système de coordonnées S, G.

12. Méthode selon la revendiction 11, dans laquelle le signal spectral RSE est obtenu en exposant les cellules à un faisceau lumineux à basse température.

13. Méthode selon la revendication 11, dans laquelle le signal spectral RSE est obtenu en exposant les cellules à un faisceau lumineux.

14. Méthode pour diagnostiquer in vitro un cancer en utilisant un spectromètre RSE, comprenant les stades suivants:

(a) isoler des lymphocytes du sang prélevé sur un malade,

(b) mélanger ces lymphocytes à une solution d'hématoporphyrine ou d'un dérivé d'hématoporphyrine,

(c) isoler ces lymphocytes du mélange et obtenir un signal spectral RSE sur ces lymphocytes,

(d) trouver une valeur de S, $S_x$, représentative de la quantité des radicaux contenus dans les lymphocytes sur la base du signal RSE, et

(e) comparer la valeur $S_x$ à une valeur prédéterminée.

15. Méthode selon la revendication 14, dans laquelle le signal spectral RSE est obtenu à basse température.

16. Méthode selon les revendications 14 et 15, dans laquelle le signal spectral RSE est obtenu en exposant les lymphocytes à un faisceau lumineux.

Fig. 1

Fig. 2

g = 2.0015

(1) | Isolation of lymphocytes from blood by centrifugation |

(2) | Mixing of lymphocytes with a solution of hematoporphyrin or its derivative |

(3) | Incubation for 10 min. at 37°C |

(4) | Isolation and washing of cells |

(5) | Introduction of cells into ESR and obtaining of ESR signals while applying a light ray |

Fig. 3

Fig. 4

RELATIVE
INTENSITY

NUMBER OF CELLS

Fig. 5

Fig.6

RELATIVE
INTENSITY

Fig. 7

FiG. 8

Fig. 9

Fig. 10

Fig.11

S ×10$^{13}$ SPINS

150 —

100 —

50 —

PERSONS IN
GOOD HEALTH

CANCER
PATIENTS

AFTER
SURGERY

Fig.12

Fig. 13

EP 0 125 651 B1

PERSONS IN CANCER AFTER
GOOD HEALTH PATIENTS SURGERY

Fig. 14

13

EP 0 125 651 B1

(a) | Measurement by ESR |

(b) | Memorizing ESR spectrum |

(c) | Obtaining $g_x$ |

(d) | Obtaining $S_x$ |

U

J

M

(e) | $S_x$ is compared with line (I) |

(g) | $g_x$ and $S_x$ are compared with line (II) or lines (I) & (III) |

(h) | Obtaining Ky or Kf |

(f) | Print out |

(i) | Ky or Kf is compared with line (IV)/(VI) or lines (V)&(I) |

Fig.15

Fig. 16